# DEMANDE DE BREVET EUROPEEN

(11) **EP 0 989 602 A1**
(43) Date de publication de la demande: **29.03.2000**
(21) Numéro de dépôt: 99203001.5
(22) Date de dépôt: 15.09.1999
(51) Int. Cl.: H01L 21/76, H01L 21/335, H01L 23/544

(54) **Procédé de réalisation d'un dispositif semiconducteur à l'aide de gravure d'un empilement de couches et de photolithographie**

(30) Priorité: 22.09.1998 FR 9811808
(71) Demandeur: Koninklijke Philips Electronics N.V., 5621 BA Eindhoven (NL)
(72) Inventeur: Baudet, Pierre, 75008 Paris (FR)
(74) Mandataire: Lottin, Claudine

(57) **Abrégé**

L'invention concerne un procédé de réalisation d'un dispositif semi-conducteur intégré sur un substrat (1) comprenant des étapes de réalisation d'un empilement de couches (2, 3, 4, 5) sur le substrat et des étapes de réalisation d'éléments de circuit par photolithographie incluant la formation d'un masque de centrage, la réalisation d'un motif de référence à travers une ouverture de ce masque, et la formation de masques de définition des éléments de circuit centrés sur ce motif de référence. Ce procédé comprend la formation d'au moins un élément de circuit (12) muni de moyens d'isolation électrique dans des zones latérales (11), la formation du masque de centrage des masques de définition des éléments de circuit intégré faite par un premier masque définissant les zones d'isolation latérales dudit élément de circuit, et la réalisation du motif de référence faite par le motif (20) formé par une gravure dont la profondeur n'excède pas l'épaisseur de la couche supérieure (5) de l'empilement de couches dans lesdites zones d'isolation latérale (11) à travers ce premier masque.

Application : Circuits intégrés monolithiques hyperfréquences

## Description

L'invention concerne un procédé de réalisation d'un dispositif semi-conducteur intégré sur un substrat comprenant des étapes de réalisation d'un empilement de couches sur le substrat et des étapes de gravures par photolithographie incluant la formation d´un masque de centrage et la réalisation d'un motif de référence à travers une ouverture de ce masque, et incluant la formation de masques de définition d'éléments de circuit centrés sur ce motif de référence.

L'invention concerne également un dispositif semi-conducteur réalisé par cette méthode.

L'invention trouve son application dans la fabrication des circuits opérant dans le domaine des ondes millimétriques, appelées circuits hyperfréquences monolithiques intégrés (MMICs) sur un substrat. Ces circuits trouvent une application particulière dans les systèmes de télécommunications et doivent être à la fois très performants et peu coûteux.

Un procédé de fabrication et un arrangement pour un circuit hyperfréquence monolithique intégré sur un substrat (MMIC) est déjà connu du brevet US 5 405 797 (Brugger). Une diode Schottky et un HFET sont réalisés selon un arrangement semi-planaire à partir d'un empilement de couches de matériaux semi-conducteurs. Le but visé est une méthode de réalisation simplifiée de l'arrangement. A cet effet, la méthode mise en oeuvre dans le document cité permet de réaliser les régions de contact de la diode Schottky et du HFET simultanément.

Par HFET, on entend un transistor à effet de champ présentant une hétérostructure. La méthode décrite pour réaliser l'arrangement comprend une première étape de croissance d'un premier groupe S de couches épitaxiales sur un substrat en GaAs semi-isolant. Ces couches S sont appropriées à la réalisation de la diode Schottky. La méthode comprend ensuite une étape de réalisation d'une couche A d'arrêt de gravure comprenant de l'aluminium (Al). Puis, la méthode comprend une étape de photolithographie pour former un masque couvrant la région de diode Schottky, et ayant des ouvertures délimitant la région du transistor HFET. Une implantation d'ions 0 est réalisée à travers ces ouvertures pour former des caissons isolants autour de la région de diode dans les couches épitaxiales précédemment réalisées. La méthode comprend ensuite une seconde étape de croissance d'un second groupe H de couches épitaxiales sur toute la surface de la couche d'arrêt, c'est-à-dire aussi bien sur la région de diode que sur les caissons isolants qui l'entourent. Les couches épitaxiales H réalisées dans cette seconde étape de croissance sont appropriées à réaliser le transistor HFET. La méthode comprend alors une seconde étape de photolithographie pour former un masque couvrant la région du transistor et ayant des ouvertures délimitant la région de la diode. A travers ces ouvertures, les couches H spécifiques au transistor qui se trouvent au-dessus des couches S de diode, dans la région de diode sont éliminées par gravure jusqu'à la couche d'arrêt A. On se trouve donc alors avec un arrangement comprenant les couches S de diodes entourées de caissons isolants, et, comprenant, disposées latéralement sur ces caissons isolants, les couches H spécifiques au transistor HFET formées en relief vis-à-vis des couches de diodes. Le transistor HFET est donc isolé de la diode latéralement par un MESA et verticalement par un caisson isolant sous-jacent. Puis le masque de photolithographie est éliminé, et les contacts des électrodes de diode et de transistor sont réalisés simultanément.

Dans un tel procédé de réalisation, il est nécessaire de former avant la première étape de photolithographie, dans une zone spécifiquement réservée au substrat, un motif de centrage des masques. Cette étape préliminaire de réalisation de motif de centrage est une étape parfaitement connue de l'homme du métier, et jamais décrite parce qu'elle est nécessairement largement utilisée dans toutes les technologies de réalisation de dispositifs semi-conducteurs mettant en oeuvre des étapes de photolithographie. Cette étape de réalisation d'un motif de centrage est à la fois indispensable et non pertinente puisque le motif de centrage n'est pas un élément de circuit intégré.

C'est donc une étape qui coûte cher en moyens et en temps, car elle met en oeuvre un masque photolithographique spécifique pour réaliser le motif de centrage, et elle vient s'ajouter aux autres étapes de réalisation des éléments de circuit intégré.

Dans le procédé de réalisation connu, il est nécessaire de réaliser une étape de formation du motif de centrage par une première étape photolithographique, puis par une seconde étape photholithographique, une gravure des couches épitaxiales superposées, nécessaires à la constitution du transistor, qui recouvrent la région de diode, afin de ne laisser subsister ces couches que dans la région du transistor, formant un MESA. Il en résulte des inconvénients. D'abord il faut deux étapes photolithographiques successives. En outre, la gravure de plusieurs couches superposées produit une hauteur de MESA substantiellement grande et défavorable à la réalisation des rubans conducteurs habituellement formés pour connecter des électrodes de l'élément isolé par MESA et des plots de contact d'autres éléments du circuit intégré situés à un plus bas niveau. Dans le cas d'un MESA substantiellement haut, les rubans conducteurs sont difficiles à réaliser avec une épaisseur uniforme et ont des tendances à la rupture aux changements de pente.

De plus, un point particulièrement désavantageux est que la gravure de plusieurs couches superposées produit des irrégularités de pente, appelées sous-gravures, dues au fait que les couches successives étant composées de matériaux différents, leurs vitesses de gravures sont différentes, d'où il résulte que les couches supérieures sont successivement en surplomb sur les couches sous-jacentes gravées les unes après les autres. Dans ce cas aussi les rubans conducteurs réalisés sur les pentes du MESA ont des tendances à la rupture. Même si, comme suggéré par le document cité, on peut réaliser une des connexions par une couche enterrée, les autres connexions doivent obligatoirement se faire par des rubans conducteurs sur la pente du MESA et sont de ce fait fragiles.

Dans le procédé connu, non seulement un masque spécifique au centrage est nécessaire, mais encore chaque masque suivant utilisé a une fonction unique dans la réalisation de l'arrangement.

Un but de l'invention est d'économiser des étapes de masquage au cours du procédé de réalisation du dispositif semi-conducteur comprenant des étapes de photolithographie.

Ce but est atteint, dans un procédé de réalisation d'un dispositif semi-conducteur intégré sur un substrat comprenant des étapes de réalisation selon la revendication 1.

Un avantage du procédé est que le premier masque des étapes de photolithographie a au moins deux fonctions: une fonction de réalisation d'un motif de centrage et une fonction de définition des zones d'isolation latérales de l'élément du circuit. De cette manière, le procédé gagne une étape de réalisation, et en outre le procédé gagne en précision, puisque le premier masque n'est pas aligné sur un motif réalisé antérieurement, mais est utilisé simultanément pour réaliser le motif et la définition des régions d'isolement.

Un autre avantage particulièrement important est que le petit MESA qui est réalisé par gravure de la couche supérieure ne comporte pas d'irrégularités de pente dues aux sous-gravures puisqu'il n'est pas gravé dans plus d'une couche : ce MESA de faible hauteur ne peut de ce fait fragiliser les rubans conducteurs réalisés sur ses pentes.

Un autre avantage est que la région réservée pour le motif de centrage sur le substrat n'est plus nécessaire et donc une surface de substrat est économisée.

Dans une mise en oeuvre, l'isolation latérale de l'élément de circuit est réalisée dans les zones définies par ledit premier masque, par implantation d'ions dans l'empilement de couches.

Un dispositif semi-conducteur réalisé selon ce procédé est moins coûteux en mise en oeuvre et en surface de substrat.

L'invention est décrite ci-après en détail en référence aux FIGs schématiques annexées, dont:
la FIG.1 montre en coupe simplifiée, un empilement de couches épitaxiales réalisées sur un substrat, pour former un transistor ayant une hétérostructure;
la FIG.2 montre, vu du dessus, un masque définissant à la fois un motif de centrage et les zones d'isolation latérales du transistor, réalisé en surface de l'empilement de couches;
la FIG.3A montre en coupe simplifiée, le masque réalisé en surface de l'empilement de couches;
la FIG.3B montre en coupe la gravure de la couche supérieure de l'empilement pour former le motif de centrage, et l'implantation ionique réalisée dans l'ouverture du masque pour former l'isolation latérale du transistor;
la FIG.4 montre vu du dessus un exemple de réalisation des électrodes de ce transistor.
la FIG.5 montre en coupe un exemple d'un tel transistor.

On décrit ci-après l'invention appliquée à titre d'exemple non limitatif à la réalisation d'un dispositif semi-conducteur du type circuit monolithiquement intégré sur un substrat pour applications hyperfréquences appelée de façon connue MMIC (Microwave Monolithic Integrated Circuit en anglais). Dans l'exemple décrit, ce circuit comprend au moins un élément actif de circuit muni de moyens d'isolation électrique latérale. La réalisation de cet élément actif comprend la réalisation, sur un substrat semi-isolant, d'un empilement de couches épitaxiales comprenant à partir du substrat une ou des couches tampon(s) d'adaptation au matériau du substrat, une ou des couches formant la région active du transistor et une ou des couches de couverture (en anglais Cap Layer ou Cover Layer) d'adaptation aux matériaux des plots de contacts ohmiques de source et drain. Un tel transistor comprend aussi un contact de grille de type Schottky de longueur substantiellement petite, généralement submicronique.

Dans la réalisation d'un tel élément actif, il est important que les contacts de source et drain soient précisément alignés l'un vis-à-vis de l'autre car le contact de grille est réalisé par alignement vis-à-vis des contacts de source et drain.

Pour de meilleures performances du transistor, l'empilement des couches est généralement réalisé par croissance épitaxiale et comprend deux couches formant une hétérostructure. Ainsi un gaz d'électrons se rassemble à l'interface de ces couches sur une faible épaisseur de quelques nanomètres. Le contact de grille est dans ce cas réalisé dans une ouverture dont le fond est à une distance prédéterminée de cette interface. Ce type de transistor est appelé PHEMT (de l'anglais Pseudomorphic High Mobility Transistor) ou HEMT pseudomorphique.

La réalisation pratique d'un tel élément actif comprend des étapes de gravure de l'ouverture de grille et des étapes de dépôt des plots de contact d'électrodes qui sont réalisées en utilisant une technique photolithographique comprenant la réalisation d'une couche de masque en une résine appropriée, l'insolation de la résine, selon un dessins très précis, pour la rendre insoluble dans les régions à protéger par masquage et pour permettre d'ouvrir des fenêtres dans des régions qui doivent subir des gravures ou des traitements.

Le positionnement du dessin pour l'insolation de la résine se fait depuis très longtemps de façon connue de l'homme du métier à partir d'un motif de centrage réalisé dans une étape préliminaire de photolithographie dans une région réservée du dispositif semi-conducteur.

La réalisation pratique du transistor comprend aussi la formation de régions d'isolation électrique réalisées tout autour du transistor. A cet effet, une étape de photolithographie est prévue pour réaliser un masque protégeant la surface du futur transistor par une couche de résine disposée sur la couche de couverture, et ouvrant une fenêtre tout autour du transistor à travers laquelle des ions sont implantés pour former ces régions d'isolation électrique.

Selon l'invention, on s'affranchit de l'étape préliminaire aux étapes de photolithographie. C'est-à-dire que, une fois l'empilement de couches épitaxiales réalisé, on ne réalise pas de motif spécifique de centrage des futures étapes photolithographiques. Selon l'invention, on réalise comme masque de motif de centrage et comme masque de définition des régions d'isolation de l'élément actif ou transistor du MMIC, un seul masque qui fait coïncider la frontière du motif de définition des régions d'isolation avec la frontière du motif de centrage. Dans l'exemple décrit plus haut, la frontière du motif de définition des régions d'isolation du transistor est la limite de la région active du transistor. Cette région active étant ainsi protégée par ce masque, on pratique d'abord une étape de gravure de la couche de couverture, partiellement vis-à-vis de son épaisseur, ou bien de son épaisseur entière, autour du masque, mais n'excédant pas cette épaisseur de la couche supérieure de l'empilement de couches, d'où il résulte un motif très faiblement en relief qui est dorénavant le motif de centrage pour des étapes de photolithographie ultérieures; et on pratique ensuite une implantation d'ions appropriés à réaliser l'isolation électrique de la région active du transistor, autour de la région active toujours protégée par ce même masque.

Donc selon l'invention, le tout premier masque réalisé lors de la fabrication du MMIC est le masque de définition de la limite entre la région active et les régions d'isolation du transistor, qui sert de masque de réalisation du motif de centrage par une gravure n'excédant pas l'épaisseur de la couche de couverture, et qui sert en même temps de masque d'implantation d'ions pour rendre isolantes les couches actives dans les régions voulues d'isolation électrique.

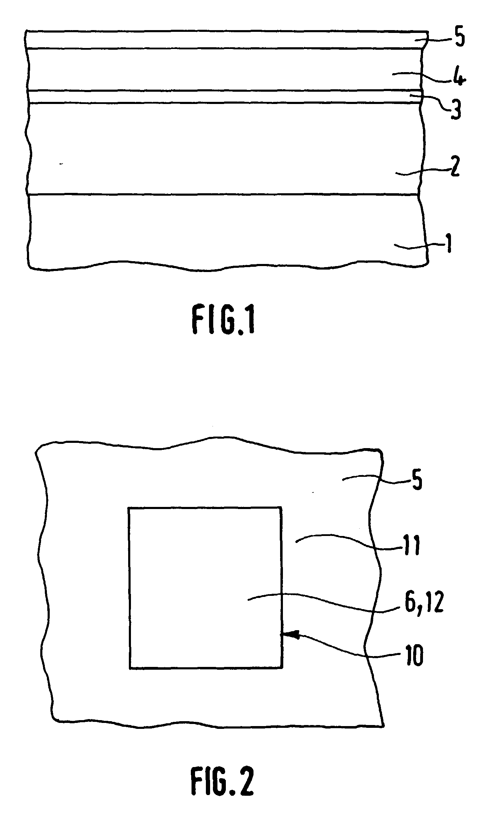

La FIG.1 représente à titre d'exemple non limitatif, un empilement de couches épitaxiales réalisées sur un substrat semi-isolant 1 en GaAs pour réaliser un PHEMT. Cet empilement comporte à partir du substrat: une couche tampon 2 en GaAs non dopé d'épaisseur de l'ordre de 0,5 à 1 µm ; deux couches adjacentes formant une hétérostructure, c'est-à-dire ayant des largeurs de bande interdite (en anglais : GAP) différentes, avec la couche 3 en InGaAs non dopée de plus faible largeur de bande interdite et d'épaisseur de l'ordre de 10 à 15 nm et avec la couche 4 en AlGaAs dopée n⁺ d'épaisseur environ 20 à 50 nm; puis la couche de couverture 5 en GaAs dopée n⁺ d'épaisseur environ 20 à 50 nm. La couche 4 constitue une couche d'arrêt de gravure vis-à-vis de la couche 5.

La FIG.2 montre vu du dessus un masque 6 formé par photolithographie dans une couche de résine appropriée couvrant la région active sous-jacente notée 12 du transistor HEMT et laissant à découvert, sur la couche de couverture 5, les régions 11 d'isolation du transistor. La limite entre la région active 12 couverte du masque 6, et les régions d'isolation 11 est notée 10.

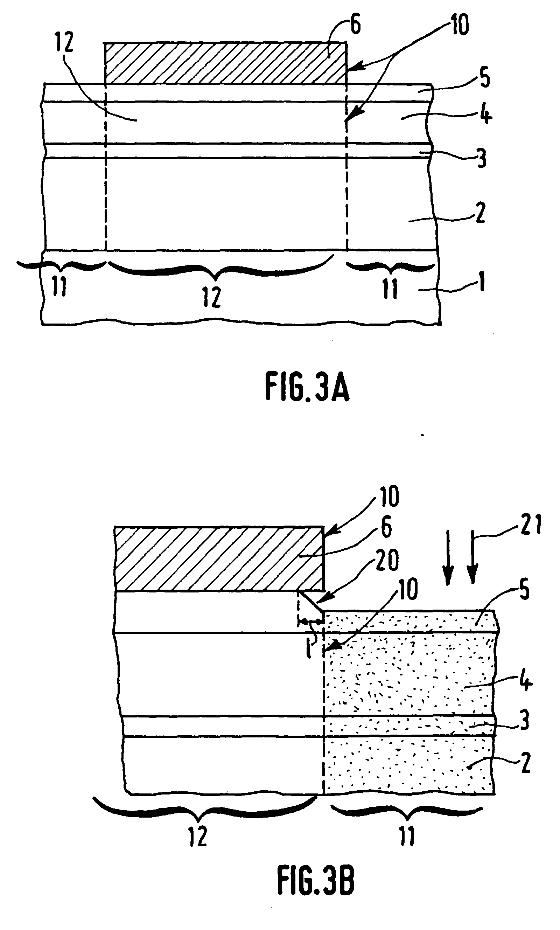

La FIG.3A montre en coupe le masque 6 formé en surface de la couche de couverture 5 et délimitant en 10 la région active 12 et les régions d'isolation 11 du transistor.

La FIG.3B montre en coupe grossie par rapport à la FIG.3A l'effet d'une première étape de gravure effectuée dans la couche de couverture 5, sur une épaisseur partielle ou sur son épaisseur totale, mais à l'exclusion de la couche 4 sous-jacente. Cette étape de gravure détermine, en coïncidence avec la limite 10, un mini-MESA noté 20. La dimension latérale ℓ de la pente de ce mini-MESA ne peut pas excéder la dimension verticale ou épaisseur de la couche 5. Le matériau de la couche 4 qui contient de l'aluminium Al arrête favorablement la gravure dès que la couche 5 est gravée. Comme cette couche 5 a une épaisseur de l'ordre de 20 à 50 nm, la grandeur 20 à 50 nm est aussi la précision du positionnement du motif de référence constitué par le motif gravé du mini-MESA 20. Le mini-MESA 20 est dorénavant le motif de référence pour le positionnement de tous les masques ultérieurs de photolithographie.

La FIG.3B montre aussi que le masque 6 sert de masque d'implantation ionique de limite 10 pour réaliser avec des ions appropriés des caissons isolants 11 autour de la zone active 12 du transistor. L'implantation ionique est pratiquée de toute manière connue de l'homme du métier, et comprend généralement un recuit. Le masque 6 est éliminé pour poursuivre la réalisation du transistor HEMT.

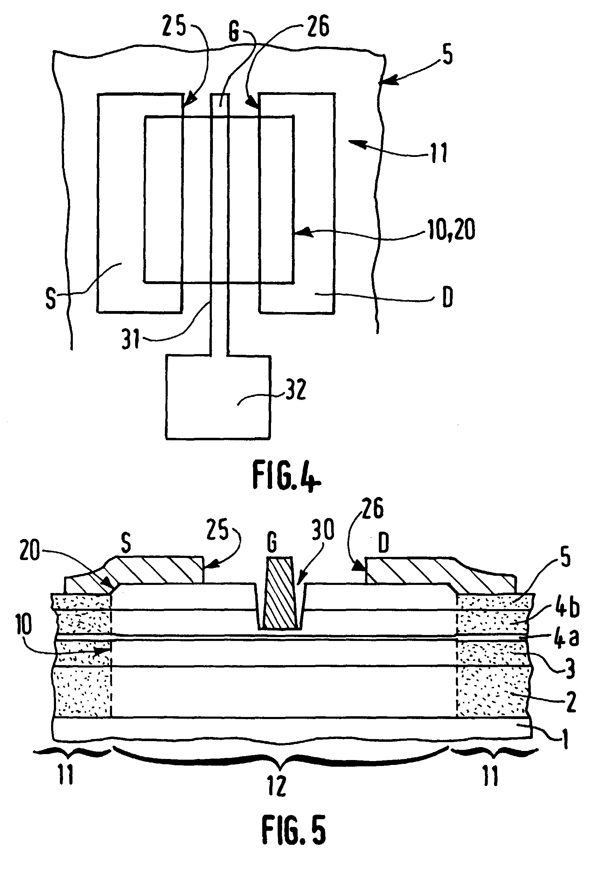

La FIG.4 montre vu du dessus un exemple de disposition des contacts d'électrode du transistor PHEMT. Ce transistor comporte une électrode de source S et une électrode de drain D qui sont des couches ohmiques déposées en surface de la couche de couverture 5 dans des ouvertures d'un nouveau masque photolithographique centré sur la couche de couverture 5 au moyen du motif de référence constitué par le mini-MESA 20.

La FIG.5 montre en coupe le transistor réalisé selon l'invention. Une fois les contacts ohmiques S et D réalisés sur la couche de couverture 5, une ouverture de grille 30 (en anglais: recess) est réalisée par gravure des couches 5 et 4, puis un contact de grille G de type Schottky est réalisé dans l'ouverture de grille. L'ouverture de grille 30 et le contact Schottky G sont centrés non pas au moyen du motif de référence 20, mais par rapport aux bords 25 et 26 des contacts ohmiques. En effet, la position de la grille G ne doit dépendre que la position de ces bords 25, 26 pour obtenir les meilleures performances du transistor. Sur la FIG.4, la couche 4 de l'hétérostructure 3,4 comporte deux couches superposées 4a, 4b avec la couche 4a d'épaisseur quelques nm non dopée.

Néanmoins, dans la mise en oeuvre de ce procédé, on a gagné une étape de masquage pour faire le motif de référence. Donc on a gagné en temps et en précision, car toute étape qui dépend d'une autre, d'abord allonge le procédé et ensuite diminue légèrement la précision, puisqu'on a toujours une petite imprécision de recentrage, comme connu de l'homme du métier.

Des avantages très importants résident en ce que le MESA est de très faible épaisseur, notamment inférieure ou de l'ordre de 50 nm, cette épaisseur étant au plus égal à celle de la couche de couverture, et en outre en ce que parce ce mini-MESA n'est réalisé que par la gravure d' une seule couche d'où il résulte qu'il ne peut pas comporter des sous-gravures formant des ruptures de pente. De ce fait, comme monté sur la FIG.4 le ruban conducteur 31 qui connecte la grille G au plot de grille 32, n'est pas fragilisé par les changements de pente.

## Revendications

1. Procédé de réalisation d'un dispositif semi-conducteur intégré sur un substrat comprenant des étapes de réalisation d'un empilement de couches sur le substrat et des étapes de réalisation d'éléments de circuit par photolithographie incluant la formation d'un masque de centrage, la réalisation d'un motif de référence à travers une ouverture de ce masque, et la formation de masques de définition des éléments de circuit centrés sur ce motif de référence, caractérisé en ce qu'il comprend la formation d'au moins un élément de circuit muni de moyens d'isolation électrique dans des zones latérales, en ce que la formation du masque de centrage des masques de définition des éléments de circuit intégré est faite par un premier masque définissant les zones d'isolation latérales dudit élément de circuit, et en ce que la réalisation du motif de référence est faite par le motif formé par une gravure dont la profondeur n'excède pas l'épaisseur de la couche supérieure de l'empilement de couches dans lesdites zones d'isolation latérale à travers ce premier masque.

2. Procédé selon la revendication 1, caractérisé en ce que l'isolation latérale de l'élément de circuit est réalisée dans les zones définies par ledit premier masque, par implantation d'ions dans l'empilement de couches.

3. Procédé selon l'une des revendications 1 ou 2, caractérisé en ce que la réalisation de l'empilement de couches comprend au moins la réalisation d'une hétérostructure pour que l'élément de circuit muni des moyens d'isolation électrique forme un transistor pseudomorphique à haute mobilité électronique.

4. Procédé selon l'une des revendications 1 à 3, caractérisé en ce que la réalisation du dispositif semi-conducteur est faite de manière monolithiquement intégrée a l'aide de matériaux semi-conducteurs du groupe III-V.
